# EUROPEAN PATENT SPECIFICATION

(11) **EP 4 195 303 B1**
(45) Date of publication and mention of the grant of the patent: **01.05.2024**
(21) Application number: 21214071.9
(22) Date of filing: 13.12.2021
(51) Int. Cl.: H01B 12/02, H10N 60/01, H10N 60/10

(54) **NONLINEAR ELEMENT DEVICE MANUFACTURED BY USING SINGLE LAYER EVAPORATION**
MITTELS EINSCHICHTVERDAMPFUNG HERGESTELLTE NICHTLINEARE ELEMENTVORRICHTUNG
DISPOSITIF À ÉLÉMENT NON LINÉAIRE FABRIQUÉ À L'AIDE D'UNE ÉVAPORATION À COUCHE UNIQUE

(43) Date of publication of application: 14.06.2023
(73) Proprietor: Karlsruher Institut für Technologie, 76131 Karlsruhe (DE)
(72) Inventor: POP, Ioan-Mihai, 76133 Karlsruhe (DE); WERNSDORFER, Wolfgang, 76137 Karlsruhe (DE); RIEGER, Dennis, 76135 Karlsruhe (DE); GÜNZLER, Simon Ruben, 76131 Karlsruhe (DE); SPIECKER, Martin, 76137 Karlsruhe (DE)
(74) Representative: Müller-Boré & Partner Patentanwälte PartG mbB

(56) References cited:
- JP-A- H01 316 978
- US-A- 5 109 164
- US-A- 5 411 937
- US-A1- 2016 028 403
- US-A1- 2018 372 653
- US-A1- 2020 027 502

## Description

The present invention relates to a nonlinear element device, a circuit comprising the nonlinear element device, use of the circuit as a quantum circuit, a method of producing a nonlinear element device and a method of producing a circuit.

A quantum bit platform that became one of the most promising architectures in the last two decades is a superconducting quantum circuit. In such a superconducting quantum circuit, a Josephson junction represents a precious resource of nonlinearity. The structure of a Josephson junction is superconductor/isolator or non-superconducting metal/superconductor. Commonly known techniques for manufacturing a Josephson junction are (i) double angle shadow evaporation and (ii) successive lithography steps, with ion milling processes in-between.

However, the above methods are complicated to implement. Accordingly, there is a need for a simplified manufacturing method.

Thus, the problem underlying the present invention is to provide a Josephson junction that can be used in a quantum circuit, and which can be manufactured easily.

The solution to the above technical problem is achieved by the invention and embodiments thereof characterized in the claims.

According to an aspect, the present invention relates to a nonlinear element device comprising:
a substrate, and
an electrode pattern arranged on the substrate,
wherein the electrode pattern is formed by a single step evaporation of a granular superconductive material as a single layer,
the electrode pattern having a uniform width of at least 50 nm to 300 nm,
wherein the electrode pattern comprises a nonlinear element in terms of a discontinuity where the electrodes are laterally displaced from one another so as to have a contact area therebetween of 150 nm² to 1000 nm², and where at least 80% of the cross sections of the electrodes at the discontinuity are not in contact with one another, and wherein the length of the nonlinear element is about 10 nm or more.

The term "nonlinear element device" generally relates to a device that does not behave linearly, i.e. that the output of the device is not directly proportional to the input given to the device. Specifically, according to the present invention, a "nonlinear element device" such as for a quantum bit, also needs to be non-dissipative and to provide enough nonlinearity starting from very low input, such as to effectively isolate the first two energy levels from the rest of the spectrum.

The substrate comprised in the nonlinear element device is not particularly limited as long as it can receive the electrode pattern. Examples of suitable materials for the substrate include silicon, silicon carbide, germanium, silicon germanium, silicongermanium-carbon, Si alloys, Ge alloys, III-V materials such as gallium arsenide, indium phosphide, aluminum arsenide, and indium arsenide, II-VI materials such as cadmium selenide, cadmium sulfide, cadmium telluride, zinc oxide, zinc selenide, zinc sulfide, and zinc telluride, sapphire, and quartz, or any combination thereof. Preferably, the substrate is sapphire or silicon, since said substrate materials are proven to have low dielectric losses. Most preferably, the substrate is a sapphire wafer.

According to the present invention, the electrode pattern is formed by evaporation of a granular superconductive material as a single layer. The single layer evaporation used according to the present invention is a thin-film lithographic method and preferably uses an evaporation mask that is located on the substrate. The evaporation mask can be formed from a layer of resist. Specifically, according to the present invention, the electrode pattern is formed on the substrate in a single evaporation step, which means that no subsequent or intermediate steps like an extra oxidation or a second resist layer are needed to form the electrode pattern. This is in contrast to the current state of the art for superconducting quantum bits fabrication which relies on multiangle shadow evaporations or successive lithographic steps with ion milling processes in-between.

The evaporation angle is preferably zero (about zero degrees) but may also be tilted as long as a single layer can be formed. Zero angle evaporation means that the evaporation direction is perpendicular to the surface of the substrate onto which the granular superconductive material is deposited. Evaporation at a titled angle means that the evaporation direction is tilted by a certain angle with respect to perpendicular, and may be up to about 20 degrees, for instance.

The wording "granular" used herein means being composed of small, discrete entities.

Further, according to the present invention, the "superconductive material" refers to a material that shows superconductive behavior at the operating temperature of the nonlinear element device. According to an embodiment, the operating temperature is 20 K or less, preferably 10 K or less, more preferably 1 K or less. The lower limit is not particularly limited and may be 10 mK for instance. Practically, the operating temperature may be 10 to 100 mK, for instance, without being limited thereto.

In a preferred embodiment, the granular superconductive material is a composite material containing metal grains embedded in a metal oxide matrix. Thereby, the structure of a Josephson junction can be easily realized. Specifically, the metal grains serve as the superconductor and the surrounding metal oxide matrix as the isolator of the structure superconductor/isolator/superconductor of the Josephson junction.

According to an embodiment of the present invention, the metal in the metal grains and the metal in the metal oxide matrix is the same. In the present invention, the metal is not particularly limited. For example, the metal may be one of aluminum, indium, tantalum, gallium, and rhenium. Preferably, the metal in the metal grains and in the metal oxide matrix is aluminum. By using aluminum as the metal of the composite material, in case that the nonlinear element device is comprised in a quantum bit, the quantum bit's transition frequency is in principle susceptible to magnetic fields in an area of (20 · 20)nm² in order to potentially couple single spin systems to the superconducting circuit.

In an embodiment, the metal grains have a grain size in the range of from 1 nm to 10 nm, preferably from 2 nm to 7 nm. The grain size can be measured by using dark-field electron microscopy, as described in e.g. G. Deutscher et al., J. Low. Temp. Phys. 10, 231-243 (1973). Document D1: US2020027502 shows a discontinuity for a superconducting wire, that may be used in a Josephson junction device.

According to an embodiment, the individual grains of the composite material agglomerate into larger effective grains due to charging effects. In said embodiment, the size of an effective grain is 50 nm or less.

In the present invention, the electrode pattern is arranged on the substrate, and has a uniform width of at least 50 nm to 300 nm, wherein the electrode pattern comprises a nonlinear element in terms of a discontinuity where the electrodes are laterally displaced from one another so as to have a contact area therebetween of 150 nm² to 1000 nm², and where at least 80% of the cross sections of the electrodes at the discontinuity are not in contact with one another. Moreover, the length of the nonlinear element is about 10 nm or more. Therefore, in the present invention, all dimensions of the electrode pattern are larger than the superconducting coherence length, ensuring the highest degree of protection against non-equilibrium excitations and achieving an excellent quantum coherence. By locally adjusting the width of the electrode pattern by introducing the discontinuity, the Josephson energy of the Josephson junction can be modulated without supressing superconductivity. Thus, according to the present invention, quantum coherence can be preserved over timescales of about 1 µs. According to the present invention, the contact area between the electrodes at the discontinuity (i.e. of the nonlinear element) is 1000 nm² or less, preferably 800 nm² or less, more preferably 600 nm² or less, and even more preferably 400 nm² or less. Further, according to the present invention, the contact area is 150 nm² or more, preferably 200 nm² or more, and more preferably 250 nm² or more. According to the present invention, the contact area of the nonlinear element is determined by the length of the nonlinear element and the height of the electrodes. When the contact area is at least 150 nm², the dimensions of the nonlinear element can be easily kept larger than the superconducting coherence length. In this regard, it should be noted that in an embodiment, the superconducting coherence length is in a range of from 5 nm to 12 nm. However, the superconducting coherence length depends on the material used and the dimensions of the electrode pattern and thus cannot be defined in terms of an absolute value.

At the discontinuity, at least 80% of the cross sections of the electrodes are not in contact with one another. Said cross sections refer to the cross section in the width direction of each electrode. In an embodiment of the present invention, at least 85% of the cross sections of the electrodes are not in contact with one another. By appropriately choosing the percentage of the cross sections of the electrodes that are not in contact with one another, the width and the height of the electrode pattern, the contact area of the electrodes can be adjusted to the claimed range.

According to a preferred embodiment, the electrode pattern has a height of less than 50 nm as measured from the surface of the substrate to the surface of the electrode pattern which is opposite the surface of the substrate. When the height is less than 50 nm, the nonlinear element device can be easily kept in the quantum regime. Preferably, the height is less than 40 nm, more preferably, less than 30 nm. Further, in an embodiment, the electrode pattern has a height of 15 nm or more, preferably of 18 nm or more. Thereby, the height can be surely kept larger than the superconducting coherence length.

The term "quantum regime" used herein refers to a set of parameters which enables a Josephson junction to sustain quantum fluctuations of the phase on the order of 2π.

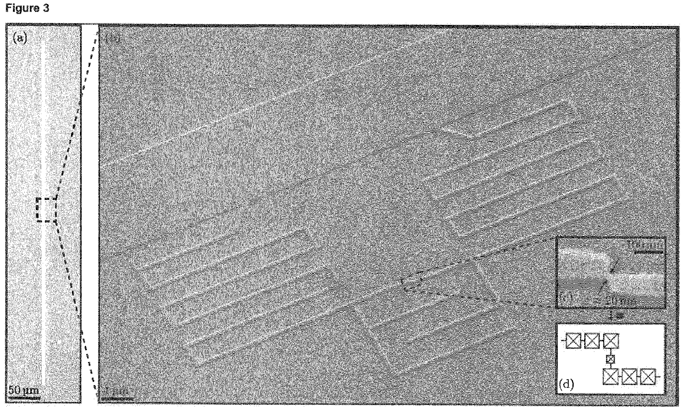

The length of the nonlinear element is preferably less than 50 nm. According to the present invention, the length of the nonlinear element is defined as the minimum length (or width) within the contact area connecting the electrodes at the discontinuity as shown in Figure 3(c) by the distance ε. Preferably, the length of the nonlinear element is 40 nm or less, particularly 30 nm or less. However, as mentioned above, the length of the nonlinear element is larger than the superconducting coherence length, which may be in the range of from 5 nm to 12 nm. The length of the nonlinear element is about 10 nm or more, preferably 15 nm or more. Most preferably, the length of the nonlinear element is about 20 nm. In case that the length of the nonlinear element is shorter than the above-mentioned upper limit of the range of the superconducting coherence length (i.e. the length of the nonlinear element being in a range of from about 10 nm to 12 nm), the width of the electrode pattern, the height of the electrode pattern and/or the contact area between the electrodes need to be adjusted appropriately such that the superconducting coherence length is shorter than the length of the nonlinear element.

The dimensions of the electrode pattern (width and height) including the dimensions of the nonlinear element in terms of contact area and length are determined by scanning electron microscopy (SEM) using calibrated SEM software.

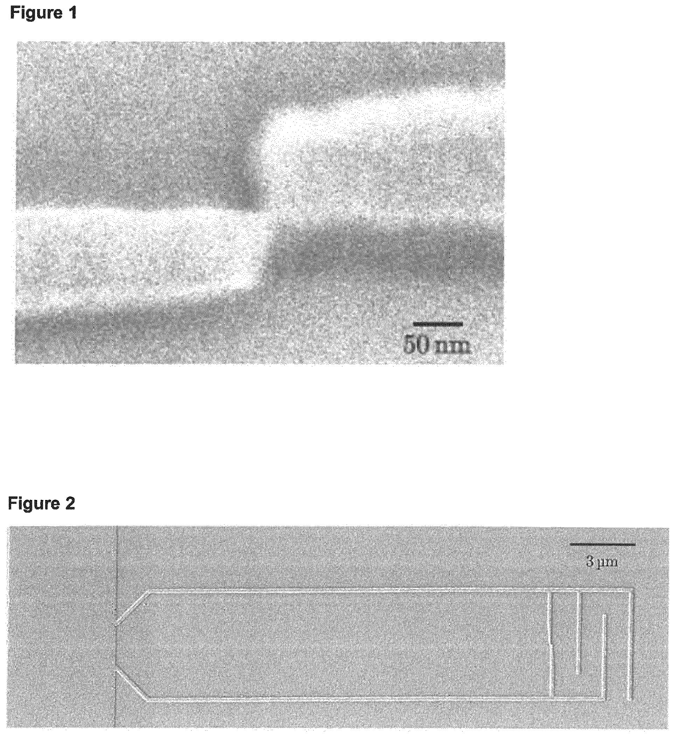

Figure 1 shows a SEM image of an example of the nonlinear element device, particularly the nonlinear element, according to the present invention with a magnification of 2 × 10⁵.

According to an aspect, the present invention relates to a circuit comprising the above-described nonlinear element device and leads connected to the device.

In an embodiment, each lead has a uniform width of at least 50 nm to 300 nm. Further, each lead may have a height of less than 50 nm as measured from the surface of the substrate to the surface of the lead which is opposite the surface of the substrate. When the height is less than 50 nm, the circuit can be easily kept in the quantum regime. Preferably, the height is less than 40 nm, more preferably, less than 30 nm. Further, in an embodiment, each lead has a height of 15 nm or more, preferably of 18 nm or more. Thereby, the height can be surely kept larger than the superconducting coherence length.

According to an embodiment, each lead is formed of the granular superconductive material used for forming the electrode pattern of the nonlinear element device. Preferably, the same material is used for the electrode pattern of the nonlinear element device and each of the leads.

In a preferred embodiment, the leads are arranged on the substrate. Preferably, the leads are formed by evaporation, preferably by zero-angle evaporation, and connected to the nonlinear element device in a continuous manner. This means that, at the contact area of the nonlinear element device and each lead, the width and height are about the same. In a preferred embodiment of the present invention, the nonlinear element device and the leads are formed by zero-angle evaporation as a single layer.

According to the above-described configuration of the circuit of the present invention, the leads are wide enough to serve as linear effective junctions, and the nonlinear element device constitutes a nonlinear junction in the quantum regime.

In an embodiment, the leads connected to the nonlinear element device are also connected to one another to form a loop. The circuit may comprise further elements such as a capacitance. Said further elements may be formed by the leads. An example of a circuit of the present invention is shown in Figure 2. Specifically, Figure 2 shows a SEM image of the circuit on the right side connected to a microwave resonator located on the left, wherein the circuit comprises a capacitance that is constituted by leads in the form of a finger capacitor. Another example of a circuit in accordance with the present invention is shown in Figure 3(b). The circuit shown in Figure 3(b) is like the one in Figure 2, except for the meander shape of the electrode pattern forming the loop. The meander shape is simply a compact way of arranging the "long wires" forming the loop. In addition to the capacitance, another relevant element is the inductance of the wires. The function of the additional elements (capacitance, inductance) and their respective values is to engineer the frequency of the quantum bit to a desired value.

When the above-described circuit is operated in a low noise radio-frequency environment and at a proper temperature of about 10 to 100 mK, for instance without being limited thereto, said circuit operates as a quantum circuit.

According to an embodiment, the quantum circuit is a quantum bit, a Superconducting Nonlinear Asymmetric Inductive Element (SNAIL), or a quantum detector. Preferably, the quantum circuit is a quantum bit.

In an embodiment, the quantum bit is connected to a microwave resonator that allows readout of the quantum bit. An example of this embodiment is shown in Figures 2 and 3(a) and (b). Preferably, the microwave resonator is arranged on the substrate and formed by zero-angle evaporation. In a preferred embodiment of the present invention, the microwave resonator and the nonlinear element device and the leads comprised in the quantum bit are formed by zero-angle evaporation as a single layer.

According to a further aspect, the present invention relates to a method of producing the above nonlinear element device comprising:
providing a substrate, and
providing an electrode pattern on the substrate by a single step evaporation of a granular superconductive material as a single layer,
wherein the single step evaporation is carried out at an oxygen partial pressure of 5×10⁻⁶ mbar to 1×10⁻³ mbar,
the electrode pattern having a uniform width of at least 50 nm to 300 nm,
wherein the electrode pattern comprises a nonlinear element in terms of a discontinuity where the electrodes are laterally displaced from one another so as to have a contact area therebetween of 150 nm² to 1000 nm², and where at least 80% of the cross sections of the electrodes at the discontinuity are not in contact with one another, and wherein the length of the nonlinear element is about 10 nm or more.

The substrate, the granular superconductive material, and the electrode pattern of the method of producing the nonlinear element device correspond to the substrate, the granular superconductive material, and the electrode pattern of the above-described nonlinear element device of the present invention.

In an embodiment, a lithography step is carried out after providing the substrate and before providing the electrode pattern on the substrate. Preferably, in the lithography step, electron beam lithography (E-Beam lithography) is used. However, any lithography method with sufficient resolution can be used, for example also UV lithography comparable to industrial semiconductor fabrication. Specifically, the substrate may be coated with a resist. The resist is not particularly limited as long as it can be used in combination with the desired lithography method. For example, an EL13/PMMA-A4 stack may be used for electron beam lithography.

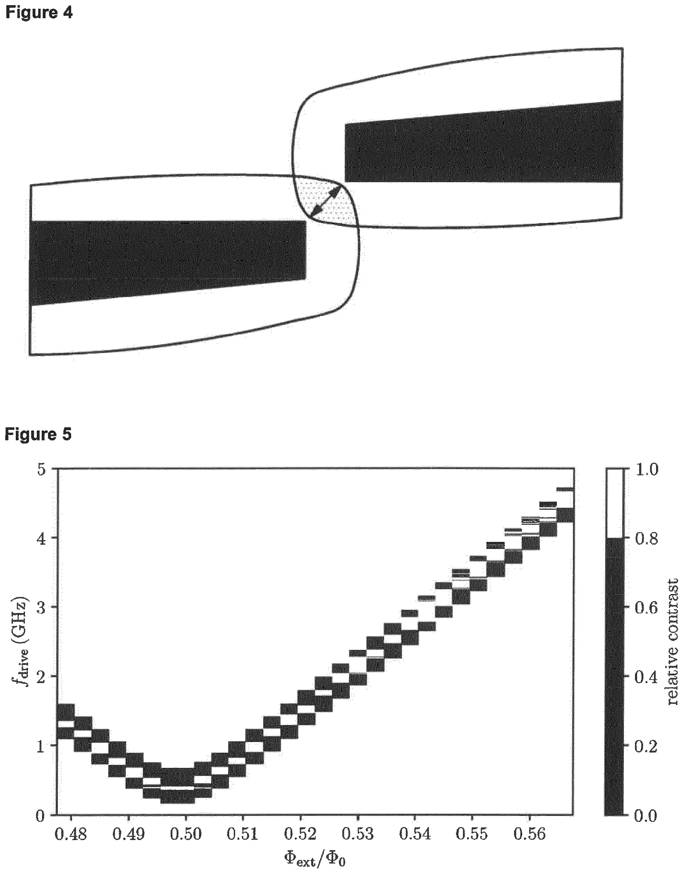

Then, the resist coated substrate is subjected to an electron beam, for instance. Since the nonlinear element device according to the present invention has dimensions approaching the resolution of electron beam lithography, producing said nonlinear element by using electron beam lithography might be challenging due to the resolution limit of the available electron beam lithography processes, particularly those available in academic cleanroom facilities. In particular, the resolution of the electron beam lithography is limited by the proximity effect: Due to a spatial broadening of the electron beam, backscattered electrons from the substrate and interaction of the electrons with the resist, the minimum exposure dosage to remove the resist with the developer is reached for a broader area than exposed by the primary electron beam, i.e. the exposed area is broadened. Therefore, in order to achieve the small structures in the quantum regime of the nonlinear element device in accordance with the present invention, a gap at the desired location of the discontinuity of the electrode pattern of the nonlinear element device is left intentionally, i.e. not written by the primary electron beam. Due to the broadening however, the resist can be exposed such that the parts forming the basis for the electrode pattern and, particularly, the discontinuity, of the present invention can still be connected. An example of an exposed resist resulting from employing the above-described electron beam lithography process is schematically shown in Figure 4. The area exposed to the primary beam is indicated by the dark lines while the light areas correspond to those areas resulting from the broadening effect. The arrow shows the above-mentioned gap that has been left intentionally. However, in case of using other nano-fabrication methodologies allowing higher resolution, the above-mentioned gap due to the broadening effect may be omitted.

Subsequent to development removing the exposed parts of the resist, a descum cleaning step may be performed to remove any remaining resist leftovers of the exposed resist, water, dust etc. above the substrate, which would potentially decrease the quality of the granular superconductive material deposited thereon. For example, for cleaning, chemical and physical etching with argon and oxygen ions may be used.

Then, the step of providing an electrode pattern on the substrate by evaporation of a granular superconductive material as a single layer may be performed. The evaporation angle is preferably zero but may also be tilted as long as a single layer can be formed, such as being tilted by about 20°, for instance.

In the step of providing an electrode pattern on the substrate by evaporating the granular superconductive material as a single layer, the evaporation, preferably zero-angle evaporation, is carried out at an oxygen partial pressure of 5×10⁻⁶ mbar to 1× 10⁻³ mbar, preferably of 1×10⁻⁵ mbar to 1×10⁻⁴ mbar.

As mentioned above, the granular superconductive material used in the method of producing a nonlinear element device corresponds to the granular superconductive material of the above-described nonlinear element device. In case that the granular superconductive material is a composite material containing metal grains embedded in a metal oxide matrix, in the step of providing the electrode pattern on the substrate by evaporation, a metal is evaporated while adjusting the oxygen partial pressure within the claimed range in order to deposit the composite material containing metal grains embedded in the metal oxide matrix onto the substrate. The evaporation may be thermal evaporation or a sputtering process, where the metal atoms are released from a target due to mechanical impacts of inert gas ions.

In an embodiment of the present invention, the deposition rate during evaporation is 10 nm/s or less, preferably 8 nm/s or less, more preferably 4 nm/s or less.

Further, according to an embodiment of the method of producing the nonlinear element device, evaporation is preferably carried out for 40 seconds or less, for 30 seconds or less or 20 seconds or less.

By appropriately adjusting the deposition rate and the duration of evaporation, structures in the quantum regime can be easily produced. Specifically, the film thickness of the single layer obtained by the single step evaporation is preferably less than 50 nm. When the film thickness is less than 50 nm, the nonlinear element device can be easily kept in the quantum regime. Preferably, the film thickness is less than 40 nm, more preferably, less than 30 nm. Further, in an embodiment, the film thickness is 15 nm or more, preferably 18 nm or more. Thereby, the film thickness can be surely kept larger than the superconducting coherence length.

According to an embodiment, the (zero-angle) evaporation may be carried out so that the temperature of the substrate is in the range of from 4 K to 700 K, preferably 100 K to 500 K. That is, the granular superconductive material may be evaporated onto the substrate which is held at room temperature (about 290 to 300 K). However, deposition on cooled or heated substrates is also possible.

In an embodiment of the present invention, after performing the step of (zero-angle) deposition, a step of removing remaining resist may be carried out. In said step, the resist which was not subjected to electron beam lithography can be removed from the substrate together with granular superconductive material possibly deposited on top thereof. The removal step may, for example, be carried out in acetone in an ultrasonic cleaner. As a result, the resist is completely removed while the granular superconductive material deposited on the substrate by the step of evaporation remains on the substrate.

Instead of the lift-off technique described above, however, it is also possible to apply etching processes. In this case, the evaporation of the granular superconductive material as a single layer is carried out first. Afterwards, the resist is coated, followed by wet or dry etching.

According to a further aspect, the present invention relates to a method of producing a circuit, comprising carrying out the above-described method of producing the nonlinear element device, and further providing leads by evaporation such that they are connected to the device. Preferably, the evaporation is a zero-angle evaporation.

The leads of the method of producing a circuit correspond to the leads of the above-described circuit of the present invention.

In an embodiment of the method of producing a circuit of the present invention, the zero-angle evaporation is single layer zero-angle evaporation, and all parts of the circuit are comprised in a single layer.

According to the present invention, by using single layer evaporation, a nonlinear element device and a circuit can be provided, wherein all dimensions are larger than the superconducting coherence length, ensuring the highest degree of protection against non-equilibrium excitations. Thereby, excellent quantum coherence over timescales of about 1 µs can be achieved. This enables the operation of coherent quantum gates on a quantum bit comprising the circuit of the present invention. The excellent quantum coherence is attributed to the fact that the present invention allows engineering the nonlinearity without suppressing superconductivity. Thus, the present invention provides a simplified manufacture of a nonlinear element device which can be used as a Josephson junction in a circuit having the above-mentioned advantageous properties.

The figures show:
Figure 1 shows a SEM image of an example of the nonlinear element device according to the present invention with a magnification of 2 × 10⁵.
Figure 2 shows a SEM image of an example of the circuit in accordance with the present invention on the right side connected to a microwave resonator located on the left, wherein the circuit comprises a capacitance that is constituted by the leads in the form of a finger capacitor.
Figure 3 shows (a) an optical microscope image of a microwave resonator used for readout of a quantum bit. (b) Angled SEM image of an example of the circuit of the present invention connected to the microwave resonator. (c) SEM image of an example of the nonlinear element device of the present invention. (d) Equivalent circuit model of an example of the nonlinear element device of the present invention and leads connected thereto.
Figure 4 shows schematically an example of exposed resist resulting from employing the electron beam lithography process. The area exposed to the primary electron beam is indicated by the dark lines while the light areas correspond to those areas resulting from the broadening effect. The arrow shows the gap that has been left intentionally when subjecting the sample to the primary electron beam.
Figure 5 shows a spectrum of a quantum bit in accordance with an embodiment of the present invention.

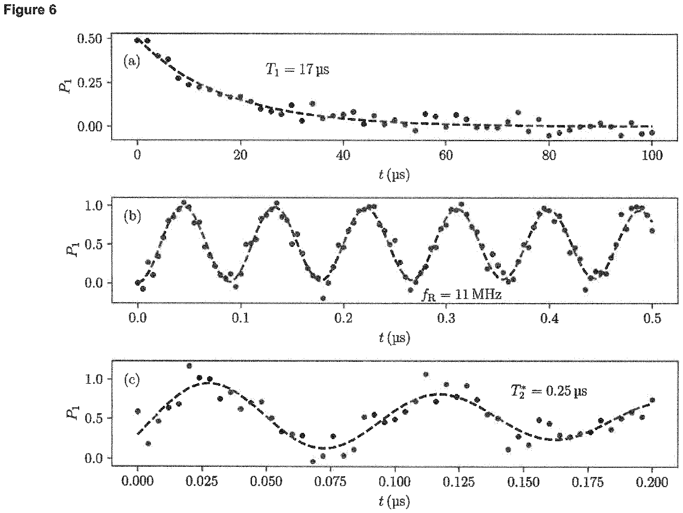

Figure 6 shows time domain experiments demonstrating the lifetimes and coherence properties of a quantum bit in accordance with an embodiment of the present invention. (a) Energy relaxation measurement, (b) Rabi oscillations revealing the two-level-nature of the quantum circuit, (c) Ramsey experiment, demonstrating the ability to put the quantum bit in a coherent superposition of the basis states. The extracted *T*₂* = 0.25 µs combined with the fast Rabi drive shown in (b) enables the coherent control of the quantum bit in accordance with an embodiment of the present invention.

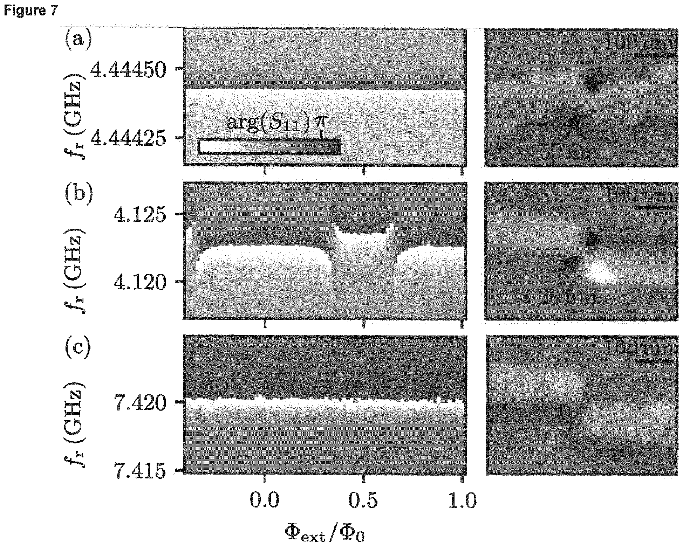

Figure 7 shows on the left the phase of the reflection coefficient measured versus external flux. The right side shows the corresponding scanning electron microscope (SEM) image of the nonlinear element of Example 1 (panel (b)) and the elements of Comparative Examples 1 and 2 (panels (a) and (c)), taken after the cooldown (in order not to corrupt/contaminate the sample).

The present invention is more specifically explained below by examples. However, the present invention is not limited to those examples.

### EXAMPLES

### Example 1

### Fabrication of a resonator-qubit system:

In a first step, a double-sided EPI polished sapphire wafer (C-plane sapphire) is coated with a first resist layer of PMMA/MAA copolymer EL13 (copolymer of polymethyl methacrylate and methyl methacrylate; 13% solids dissolved in ethyl lactate) under the following conditions:
- Spin parameters: 1000 rpm/s acceleration, spin speed 2000 rpm, spin time 100 s;
- Baking on hot plate: 200°C, 5 min.

Thereafter, a second resist layer is provided using 950PMMA (A4, 4% solids dissolved in anisole) under the following conditions:
- Spin parameters: 1000 rpm/s acceleration, spin speed 2000 rpm, spin time 100 s;
- Baking on hot plate: 200°C, 5 min.

An antistatic layer is deposited thereon by chromium evaporation at a thickness of 20 nm.

Afterwards, E-Beam lithography is performed using an E-Beam writer VB6 UHR-EWF at an acceleration voltage of 100 kV. Subsequent to the development removing the exposed parts of the resist using a chromium etch for 60 s and a spray development of methyl isobutyl ketone-isopropyl alcohol (1:3) for 40 s, a descum cleaning step is performed to remove any remaining resist leftovers, water, dust etc. above the bare sapphire wafer. The cleaning is done for 15 s by chemical and physical etching with argon and oxygen ions, generated by a Kaufman ion source (oxygen flow: 1 sccm (standard cubic centimeters per minute), argon flow: 10 sccm, discharge voltage: 40 V, beam voltage: 200 V, beam current: 15 mA).

In the next step, a 20 nm thick granular aluminum film is deposited onto the wafer by thermal evaporation of aluminum (about 1 nm/s) in an oxygen atmosphere inside a Prevac shadow evaporation system. In this step, after titanium gettering (0.2 nm/s for 2 min with shutter closed, then 3 min waiting time), the oxygen flow (which forms a dynamic equilibrium between insertion of oxygen and removal with the turbo pump) and the aluminum deposition rate are the tuning knobs that need to be controlled for a reliable deposition of granular aluminum, i.e. a reliable normal state resistivity. The oxygen flow was 9 sccm.

In a lift-off process, the remaining resist is removed from the wafer together with the granular aluminum film on top (5 minutes in acetone in an ultrasonic cleaner at 60°C, then immersion in ethanol and blow drying with a nitrogen gun).

The obtained resonator-qubit circuit is shown in Figure 3. As shown in Figure 3(c) and Figure 7(b), the length of the nonlinear element was about 20 nm resulting in a contact area of about 400 nm². Further, at least 80% of the cross sections of the electrodes at the discontinuity are not in contact with one another.

### Device parameters

The parameters of the obtained device (quantum bit) are analyzed under the following conditions:
- Fluxonium Inductance: 96 nH
- Fluxonium Capacitance: 1.1 fF
- Fluxonium Junction Josephson Energy: 120 GHz

Figure 5 is measured using a vector network analyzer to monitor the readout resonator and an additional microwave generator to probe the qubit frequency. The dependency of the transition frequency on external flux embodies typical features of a flux quantum bit spectra, first and foremost a parabolic minimum at a suitable operation frequency in the low GHz regime.

The time domain data in Figure 6 is measured using an arbitrary waveform generator to send pulsed microwave signals to the qubit and resonator. The results shown in Figure 6 demonstrate the lifetimes and coherence properties of the quantum bit of Example 1. The dashed line in Fig. 6(a) represents an exponential fit to the data from which a *T*₁ decay time on the order of tens of µs was extracted. Rabi oscillations shown in Fig. 6(b) reveal the two-level-nature of the quantum circuit. A sinusoidal fit with exponential envelope yields a Rabi frequency of 11 MHz and a negligible decay over a timescale of 0.5 µs. Fig. 6(c) shows a Ramsey experiment, demonstrating the ability to put the quantum bit in a coherent superposition of the basis states. The extracted *T*₂* = 0.25 µs combined with the fast Rabi drive shown in (b) enables the coherent control of the quantum bit in accordance with the present invention.

### Comparative Example 1

An element was obtained in the same manner as in Example 1 except that the position of the primary electron beam during E-Beam lithography was shifted compared to the respective position in Example 1.

The obtained element is shown in Figure 7(a), right side. The length of the nonlinear element (indicated by the arrows) was 50 nm. The resulting element, however, did not fulfill the feature that at least 80% of the cross sections of the electrodes at the discontinuity are not in contact with one another.

### Comparative Example 2

An element was obtained in the same manner as in Example 1 except that the position of the primary electron beam during E-Beam lithography was shifted compared to the respective position in Example 1.

The obtained element is shown in Figure 7(c), right side. As shown in the figure, the electrodes are interrupted, i.e. they do not have a contact area.

Figure 7, left side, is measured using a vector network analyzer. It shows measured readout resonator flux sweeps indicating a successful prototype (panel (b), a nonlinear element in accordance with that produced in Example 1) and failed prototypes (panels (a) and (c) relating to the elements of Comparative Examples 1 and 2, respectively). The sample is coated with gold for SEM imaging in (a) leading to the visible grainy structure. The samples in (b) and (c) are coated with carbon, which does not add structure to the images.
(a) The resonator frequency does not depend on external flux in this field range, because the contact of the cross sections of the electrodes at the discontinuity is too large (i.e. the element does not fulfill that at least 80% of the cross sections of the electrodes at the discontinuity are not in contact with one another). Therefore, the element is too linear and no tunneling occurs.
(b) The flux sweep shows periodic avoided level-crossings, which are the signature of a functional qubit attached to the resonator. The nonlinear element of Figure 7(b) has a contact area of 400 nm², a length ε of about 20 nm and at least 80% of the cross sections of the electrodes at the discontinuity are not in contact with one another.
(c) The resonator frequency does not depend on external flux in this field range because the electrodes of the element are interrupted, the external field does not influence the resonator *via* the attached loop.

## Claims

1. A nonlinear element device comprising:
a substrate, and
an electrode pattern arranged on the substrate,
wherein the electrode pattern is formed by a single step evaporation of a granular superconductive material as a single layer,
the electrode pattern having a uniform width of at least 50 nm to 300 nm,
wherein the electrode pattern comprises a nonlinear element in terms of a discontinuity where the electrodes are laterally displaced from one another so as to have a contact area therebetween of 150 nm² to 1000 nm², and where at least 80% of the cross sections of the electrodes at the discontinuity are not in contact with one another, and
wherein the length of the nonlinear element is about 10 nm or more.

2. The nonlinear element device according to claim 1,
wherein the granular superconductive material is a composite material containing metal grains embedded in a metal oxide matrix.

3. The nonlinear element device according to claim 2,
wherein the metal grains have a grain size in the range of from 1 nm to 10 nm.

4. The nonlinear element device according to claim 2 or 3,
wherein the metal in the metal grains and in the metal oxide matrix is aluminum.

5. The nonlinear element device according to any one of claims 1 to 4,
wherein the substrate is sapphire or silicon.

6. The nonlinear element device according to any one of claims 1 to 5,
wherein the electrode pattern has a height of less than 50 nm as measured from the surface of the substrate to the surface of the electrode pattern which is opposite the surface of the substrate.

7. A circuit comprising the nonlinear element device according to any one of claims 1 to 6, and
leads connected to the device.

8. Use of the circuit according to claim 7 as a quantum circuit.

9. A method of producing a nonlinear element device comprising:
providing a substrate, and
providing an electrode pattern on the substrate by a single step evaporation of a granular superconductive material as a single layer,
wherein the single step evaporation is carried out at an oxygen partial pressure of 5×10⁻⁶ mbar to 1×10⁻³ mbar,
the electrode pattern having a uniform width of at least 50 nm to 300 nm,
wherein the electrode pattern comprises a nonlinear element in terms of a discontinuity where the electrodes are laterally displaced from one another so as to have a contact area therebetween of 150 nm² to 1000 nm², and where at least 80% of the cross sections of the electrodes at the discontinuity are not in contact with one another, and
wherein the length of the nonlinear element is about 10 nm or more.

10. The method of producing a nonlinear element device according to claim 9, wherein the deposition rate during evaporation is 10 nm/s or less.

11. The method of producing a nonlinear element device according to claim 9 or 10, wherein the evaporation is carried out at an evaporation angle of about zero degrees.

12. A method of producing a circuit, comprising carrying out the method of producing a nonlinear element device according to any one of claims 9 to 11, and
further providing leads by evaporation such that they are connected to the device.

13. The method of producing a circuit according to claim 12, wherein the evaporation is single layer zero-angle evaporation, and
all parts of the circuit are comprised in a single layer.

## Patentansprüche

1. Vorrichtung mit nichtlinearem Element, umfassend:
ein Substrat, und
eine auf dem Substrat angeordnete Elektrodenstruktur,
wobei die Elektrodenstruktur durch ein einstufiges Aufdampfen eines granularen supraleitenden Materials als eine einzige Schicht gebildet ist,
die Elektrodenstruktur eine gleichmäßige Breite von mindestens 50 nm bis 300 nm aufweist,
wobei die Elektrodenstruktur ein nichtlineares Element hinsichtlich einer Diskontinuität umfasst, bei der die Elektroden seitlich voneinander versetzt sind, so dass sie eine Kontaktfläche zwischen sich von 150 nm² bis 1000 nm² aufweisen, und bei der mindestens 80 % der Querschnitte der Elektroden an der Diskontinuität nicht miteinander in Kontakt sind, und
wobei die Länge des nichtlinearen Elements etwa 10 nm oder mehr beträgt.

2. Vorrichtung mit nichtlinearem Element nach Anspruch 1,
wobei das granulare supraleitende Material ein Verbundmaterial ist, das Metallkörner enthält, die in eine Metalloxidmatrix eingebettet sind.

3. Vorrichtung mit nichtlinearem Element nach Anspruch 2,
wobei die Metallkörner eine Korngröße im Bereich von 1 nm bis 10 nm aufweisen.

4. Vorrichtung mit nichtlinearem Element nach Anspruch 2 oder 3,
wobei das Metall in den Metallkörnern und in der Metalloxidmatrix Aluminium ist.

5. Vorrichtung mit nichtlinearem Element nach einem der Ansprüche 1 bis 4, wobei das Substrat Saphir oder Silizium ist.

6. Vorrichtung mit nichtlinearem Element nach einem der Ansprüche 1 bis 5,
wobei die Elektrodenstruktur eine Höhe von weniger als 50 nm aufweist, gemessen von der Oberfläche des Substrats zu der Oberfläche der Elektrodenstruktur, die der Oberfläche des Substrats gegenüberliegt.

7. Schaltung, umfassend das nichtlineare Element nach einem der Ansprüche 1 bis 6 und
Leitungen, die mit der Vorrichtung verbunden sind.

8. Verwendung der Schaltung nach Anspruch 7 als eine Quantenschaltung.

9. Verfahren zur Herstellung einer Vorrichtung mit nichtlinearem Element, umfassend:
Bereitstellen eines Substrats, und
Bereitstellen einer Elektrodenstruktur auf dem Substrat durch ein einstufiges Aufdampfen eines granularen supraleitenden Materials als eine einzige Schicht,
wobei das einstufige Aufdampfen bei einem Sauerstoffpartialdruck von 5×10⁻⁶ mbar bis 1×10⁻³ mbar durchgeführt wird,
die Elektrodenstruktur eine gleichmäßige Breite von mindestens 50 nm bis 300 nm aufweist,
wobei die Elektrodenstruktur ein nichtlineares Element hinsichtlich einer Diskontinuität umfasst, bei der die Elektroden seitlich voneinander versetzt sind, so dass sie eine Kontaktfläche zwischen sich von 150 nm² bis 1000 nm² aufweisen, und bei der mindestens 80 % der Querschnitte der Elektroden an der Diskontinuität nicht miteinander in Kontakt sind, und
wobei die Länge des nichtlinearen Elements etwa 10 nm oder mehr beträgt.

10. Verfahren zur Herstellung einer Vorrichtung mit nichtlinearem Element nach Anspruch 9, wobei die Abscheidungsrate während des Aufdampfens 10 nm/s oder weniger beträgt.

11. Verfahren zur Herstellung einer Vorrichtung mit nichtlinearem Element nach Anspruch 9 oder 10, wobei das Aufdampfen bei einem Aufdampfwinkel von etwa null Grad durchgeführt wird.

12. Verfahren zur Herstellung einer Schaltung, umfassend das Durchführen des Verfahrens zur Herstellung einer Vorrichtung mit nichtlinearem Element nach einem der Ansprüche 9 bis 11 und
weiter das Bereitstellen von Leitungen durch Aufdampfen, so dass sie mit der Vorrichtung verbunden sind.

13. Verfahren zur Herstellung einer Schaltung nach Anspruch 12, wobei das Aufdampfen ein Einschicht-Nullwinkel-Aufdampfen ist, und
alle Teile der Schaltung in einer einzigen Schicht umfasst sind.

## Revendications

1. Dispositif à élément non linéaire comprenant :
un substrat, et
un motif d'électrode agencé sur le substrat,
dans lequel le motif d'électrode est formé par une évaporation à étape unique d'un matériau supraconducteur granulaire en tant que couche unique,
le motif d'électrode ayant une largeur uniforme d'au moins 50 nm à 300 nm,
dans lequel le motif d'électrode comprend un élément non linéaire en termes d'une discontinuité où les électrodes sont déplacées latéralement l'une de l'autre de manière à avoir une zone de contact entre elles de 150 nm² à 1000 nm², et où au moins 80 % des sections transversales des électrodes au niveau de la discontinuité ne sont pas en contact l'une avec l'autre, et
dans lequel la longueur de l'élément non linéaire est d'environ 10 nm ou plus.

2. Dispositif à élément non linéaire selon la revendication 1,
dans lequel le matériau supraconducteur granulaire est un matériau composite contenant des grains métalliques incorporés dans une matrice d'oxyde métallique.

3. Dispositif à élément non linéaire selon la revendication 2,
dans lequel les grains métalliques ont une taille de grain dans la plage allant de 1 nm à 10 nm.

4. Dispositif à élément non linéaire selon la revendication 2 ou 3,
dans lequel le métal dans les grains métalliques et dans la matrice d'oxyde métallique est l'aluminium.

5. Dispositif à élément non linéaire selon l'une quelconque des revendications 1 à 4,
dans lequel le substrat est du saphir ou silicium.

6. Dispositif à élément non linéaire selon l'une quelconque des revendications 1 à 5,
dans lequel le motif d'électrode a une hauteur inférieure à 50 nm telle que mesurée de la surface du substrat à la surface du motif d'électrode qui est à l'opposé de la surface du substrat.

7. Circuit comprenant le dispositif à élément non linéaire selon l'une quelconque des revendications 1 à 6, et
des fils connectés au dispositif.

8. Utilisation du circuit selon la revendication 7 en tant que circuit quantique.

9. Procédé de production d'un dispositif à élément non linéaire comprenant :
fournir un substrat, et
fournir un motif d'électrode sur le substrat par une évaporation à étape unique d'un matériau supraconducteur granulaire en tant que couche unique,
dans lequel l'évaporation à étape unique est réalisée à une pression partielle d'oxygène de 5×10⁻⁶ mbar à 1×10⁻³ mbar,
le motif d'électrode ayant une largeur uniforme d'au moins 50 nm à 300 nm,
dans lequel le motif d'électrode comprend un élément non linéaire en termes d'une discontinuité où les électrodes sont déplacées latéralement l'une de l'autre de manière à avoir une zone de contact entre elles de 150 nm² à 1000 nm², et où au moins 80 % des sections transversales des électrodes au niveau de la discontinuité ne sont pas en contact l'une avec l'autre, et
dans lequel la longueur de l'élément non linéaire est d'environ 10 nm ou plus.

10. Procédé de production d'un dispositif à élément non linéaire selon la revendication 9,
dans lequel le taux de dépôt au cours de l'évaporation est de 10 nm/s ou moins.

11. Procédé de production d'un dispositif à élément non linéaire selon la revendication 9 ou 10,
dans lequel l'évaporation est réalisée à un angle d'évaporation d'environ zéro degré.

12. Procédé de production d'un circuit, comprenant réaliser le procédé de production d'un dispositif à élément non linéaire selon l'une quelconque des revendications 9 à 11, et
fournir en outre des fils par évaporation de sorte qu'ils sont connectés au dispositif.

13. Procédé de production d'un circuit selon la revendication 12, dans lequel l'évaporation est une évaporation à angle nul à couche unique, et
toutes les parties du circuit sont comprises dans une couche unique.
